# EUROPEAN PATENT SPECIFICATION

(11) **EP 0 899 357 B1**
(45) Date of publication and mention of the grant of the patent: **26.10.2005**
(21) Application number: 98306921.2
(22) Date of filing: 28.08.1998
(51) Int. Cl.: C23C 14/54, C23C 14/56, C23C 14/32

(54) **Vapor deposition production coating system**
Produktionssystem zum Beschichten mittels Aufdampfung
Système de production pour déposer des revêtements de la phase vapeur

(30) Priority: 30.08.1997 US 919130
(43) Date of publication of application: 03.03.1999
(73) Proprietor: UNITED TECHNOLOGIES CORPORATION, Hartford, CT 06101 (US)
(72) Inventor: Beers, Russell A., Palm Beach Gardens, Florida 33418 (US); Marszal, Dean N., Southington, Connecticut 06489 (US); Noetzel, Allan A., Singer Island, Florida 33404 (US); Sileo, Gerard A., Jupiter, Florida 33477 (US); Hendricks, Robert E., Port Saint Lucie, Florida 34953 (US); Wright, Robert J., Charlestown, West Virginia 25414 (US); Ervin, David R., Royal Palm Beach, Florida 33411 (US)
(74) Representative: Leckey, David Herbert

(56) References cited:
- US-A- 4 749 465
- US-A- 5 380 420
- US-A- 5 597 609

## Description

This invention relates to vapor deposition apparatus in general, and to production systems in particular.

Vapor deposition as a means for applying a coating to a substrate is a known art that includes processes such as chemical vapor deposition, physical vapor deposition, and cathodic arc vapor deposition. Chemical vapor deposition involves introducing reactive gaseous elements into a deposition chamber containing one or more substrates to be coated. Physical vapor deposition involves providing a source material and a substrate to be coated in a evacuated deposition chamber. The source material is converted into vapor by an energy input, such as heating by resistive, inductive, or electron beam means. Cathodic arc vapor deposition involves a source material and a substrate to be coated placed in an evacuated deposition chamber containing only a relatively small amount of gas. An arc, traveling between the cathode and an anode, vaporizes the cathode into a plasma containing atoms, molecules, ions, electrons, and particles. Positively charged ions liberated from the cathode are attracted toward any object within the deposition chamber having a negative electric potential relative to the positively charged ion. Some deposition processes maintain the substrate to be coated at the same electric potential as the anode. Other processes use a biasing source to lower the potential of the substrate and thereby make the substrate relatively more attractive to the positively charged ions. In either case, the substrate becomes coated with the vaporized material liberated from the cathode.

Presently available cathodic arc coaters typically use a cooled cathode fixed in place within the coater. One cooling scheme provides a manifold attached to the cathode that permits the passage of coolant between the cathode and manifold. Another scheme uses coolant piping connected to a hollow cathode. A problem with either scheme is that the cathode must be machined to accept the manifold or piping. Not all cathode materials are amenable to machining and even where possible, machining adds significantly to the cost of the consumable cathode. Another problem with the above described "direct cooling" schemes is the labor and time required to replace the cathode when its useful life has expired. In the previous example where a manifold (or piping) is mechanically attached to the cathode, the manifold (or piping) must be detached from the old cathode and attached to a new one, and the deposition chamber subsequently cleaned of coolant. For those applications which require cathode replacement after each coating run, the labor costs and down time can be considerable.

Present vapor deposition coaters are typically not well adapted for production environments, where it is desirable to establish a continuous, high-volume stream of parts passing through numerous manufacturing operations. Continuous processing helps minimize downtime between operations and speeds up production rates. Presently available low volume laboratory coaters commonly use the previously mentioned fixed cathode that must be replaced after one or two runs. The effort required to replace the cathode, and the limited volume of laboratory coaters, make laboratory coaters an impractical means of providing a continuous, high-volume stream of coated parts. High-volume batch coaters, on the other hand, are capable of coating large numbers of parts, but do not provide a continuous stream. Specifically, the length of time required to fill a large batch coater from upstream manufacturing operations and the duration of the coating run make large batch coaters ill suited for continuous production environments.

In short, what is needed is a vapor deposition production system that operates efficiently, one capable of repeatably providing a high quality coating on a substrate, one capable of providing a continuous, high-volume stream of coated parts, and one that operates cost effectively.

According to the present invention, a vapor deposition production system for coating substrates is provided which includes a plurality of vapor deposition coaters, a plurality of platters, a platter docking station, a shuttle track, and means for transporting the platters between the coaters and the platter docking station. The shuttle track connects the platter docking station and the coaters. Platters may be selectively removed from the coaters and transported along the shuttle track to the platter docking station where processed substrates are unloaded from the platters and unprocessed substrates loaded on to the platters.

An advantage of the present invention at least in is preferred embodiments is that a vapor deposition production system for coating substrates is provided that is capable of producing a continuous high-volume stream of coated substrates. One preferred characteristic that gives the present invention that capability is the cathode utilized in each coater. Specifically, the cathode is not directly connected to a cooling source, requires minimum machining, and is easily installed and removed. Downtime attributable to cathode removal and installation is effectively eliminated. Another characteristic that gives the present invention production system the capability of producing a continuous high-volume stream of coated substrates is the handling system which includes the platters, shuttle track, and platter docking station. These elements, by themselves, minimize the time and labor required to process a large volume of parts. Automation of the coaters, platters, shuttle track, and platter docking station, as is later described, can even further reduce the time and labor required, and facilitate production of a high-volume stream of coated substrates.

Another advantage of the present invention at least in its preferred embodiments is that an efficient, cost effective vapor deposition production system for coating substrates is provided. The characteristics stated above that give the present invention production system the capability of producing a continuous high-volume stream of coated substrates are the same characteristics that make it efficient and cost effective. In addition, the relatively inexpensive form of the consumable cathode (e.g., minimal machining required) minimizes the cost per run, consequently increasing the cost effectiveness of the system.

A preferred embodiment of the invention will now be described, by way of example only, and with reference to the accompanying drawings, in which:
FIG.1 is a diagrammatic view of the present invention vapor deposition production system for coating substrates.
FIG.2 is a diagrammatic view of one of the plurality of coaters in the present invention vapor deposition production system for coating substrates.
FIG.3 is a diagrammatic embodiment of a disk-shaped cathode and contactor of a present invention coater.
FIG.4 is a diagrammatic embodiment of an annular-shaped cathode and contactor of a present invention coater.
FIG.5 is a diagrammatic top view of a platter.
FIG.6 is a sectional view of the platter shown in FIG.5.
FIG.7 is a diagrammatic perspective view of the shuttle car, bearing a platter, on a section of shuttle track.

### I. Apparatus

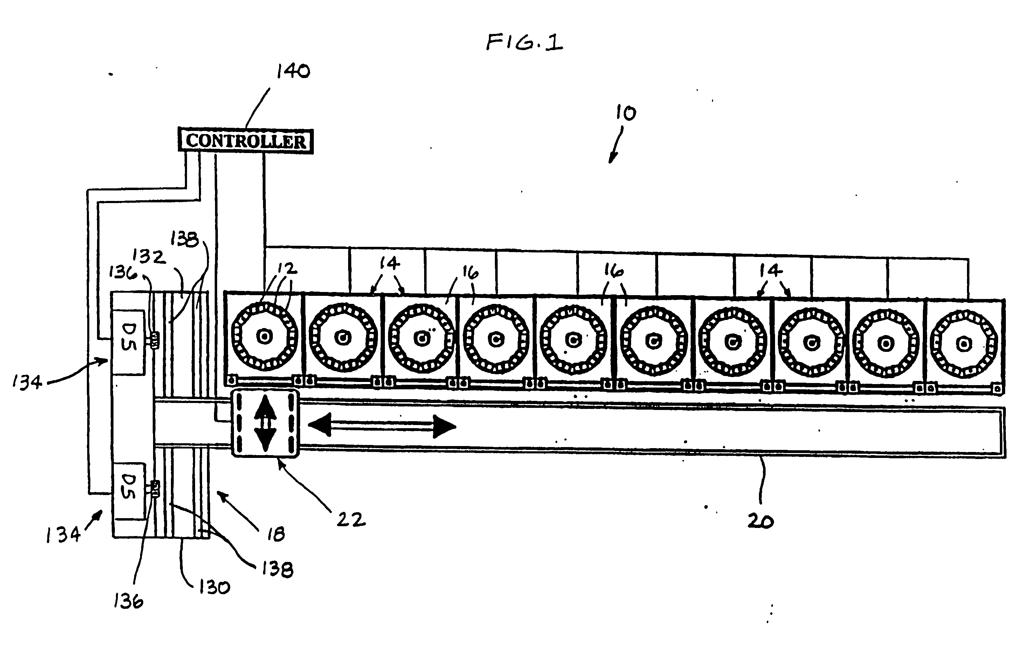

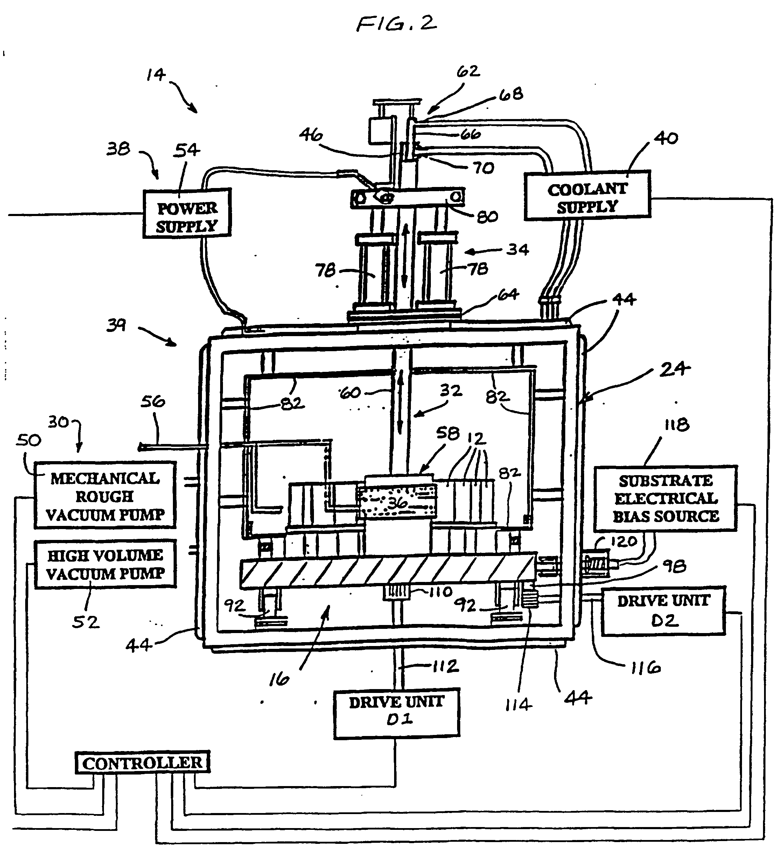

Referring to FIGS. 1 and 2, a vapor deposition production system 10 for coating substrates 12 includes a plurality of vapor deposition coaters 14, a plurality of platters 16, a platter docking station 18, a shuttle track 20, and means 22 for driving a platter 16 between a coater 14 and the platter docking station 18. The vapor deposition coaters 14 are preferably cathodic arc type coaters, although other vapor deposition coaters may be used alternatively. Each cathodic arc coater 14 (see FIG.2) includes a vessel 24, means 30 for maintaining a vacuum in the vessel 24, a contactor 32, an actuator 34 for selectively actuating the contactor 32 into electrical contact with the cathode 36, and means 38 for sustaining an arc of electrical energy between the cathode 36 and an anode 39. A coolant supply 40 maintains the coater 14 within acceptable temperatures by cycling coolant through cooling passages 44,46 within the vessel 24 and contactor 32. The means 30 for maintaining a vacuum in the vessel 24 preferably includes a mechanical rough vacuum pump 50 and a high-volume diffusion-type vacuum pump 52 piped to the interior of the vessel 24. Other vacuum means may be used alternatively. The means 38 for sustaining an arc of electrical energy between the cathode 36 and an anode 39 includes a direct current (D.C.) power supply 54. The vessel 24 is preferably electrically connected to act as an anode, although an anode (not shown) may be positioned within the vessel 24. An arc initiator 56, maintained at or near the electrical potential of the anodic vessel 24, is used to initiate an arc.

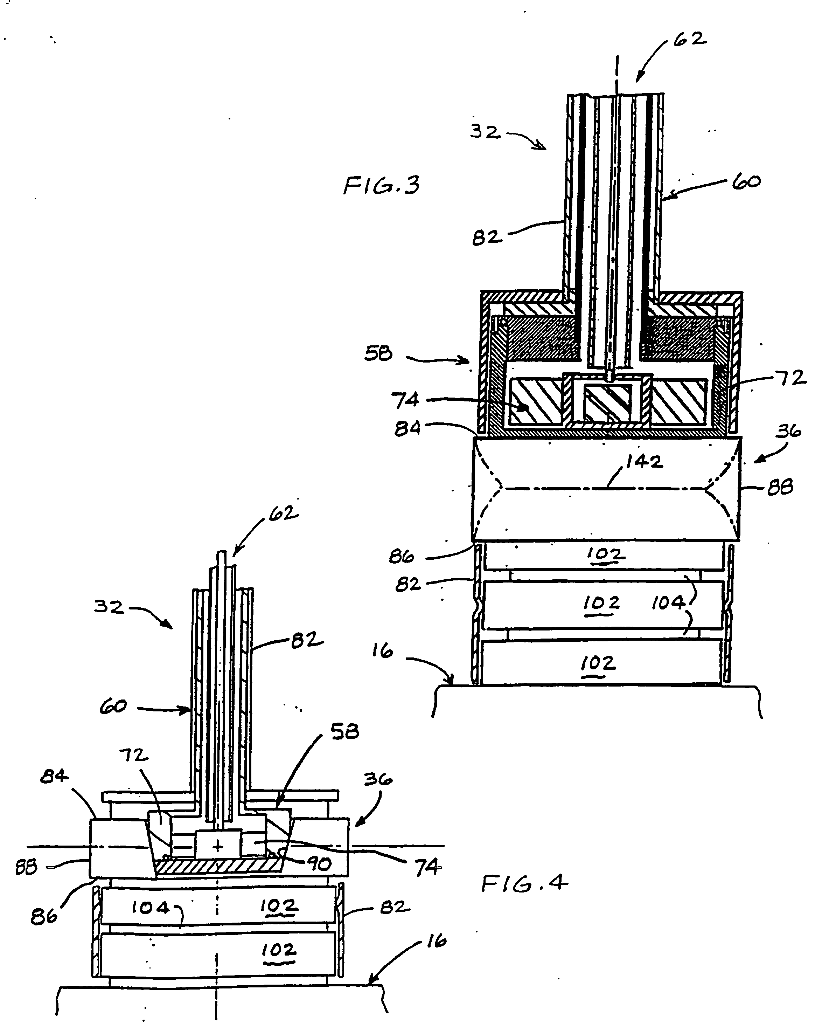

The contactor 32 includes a head 58 attached to a shaft 60, and means 62 for cooling the contactor 32. The head 58 is positioned inside the vessel 24 and the shaft 60 extends from the head 58 to outside the vessel 24. An insulative disk 64 electrically insulates the contactor 32 from the vessel 24. The means 62 for cooling the contactor 32 preferably includes a cooling tube 66 coaxially positioned within the shaft 60, a coolant inlet port 68 connected to the cooling tube 66, and a coolant exit port 70 connected to the passage 46 formed between the coaxial coolant tube 66 and shaft 60. The coaxial arrangement between the cooling tube 66 and the shaft 60 allows coolant to flow in the cooling tube 66 and exit via the passage 46 between the shaft 60 and the cooling tube 66, or vice versa. The head 58 (see FIGS. 3 and 4) includes a cup 72 and a magnetic field generator 74. The magnetic field generator 74 is disposed within the cup 72 and the cup 72 is fixed to the contactor shaft 60. The magnetic field generator 74 generates a magnetic field that runs parallel to the evaporative surface 88 (described below) of the cathode 36. The actuator 34 (see FIG.2) for selectively actuating the contactor 32 into electrical contact with the cathode 36 includes a pair of two-way actuating cylinders 78 (hydraulic or pneumatic) acting between a shaft flange 80 attached to the contactor shaft 60 and the vessel 24. Mechanical apparatus (not shown) may be used in place of the actuating cylinders 78.

Deflector shields 82 are used throughout the coater 14 to confine the vaporized cathode materials in the area of the substrates 12. The deflector shields 82 attached to the vessel 24 , platter 16, and contactor 32 also minimize undesirable material build-up on those surfaces. In the preferred embodiment, the deflector shields 82 attached to the vessel 24 are electrically connected to the vessel 24 and are made of an electrically conductive material resistant to corrosion, such as stainless steel.

In a first embodiment (FIG.3), the cathode 36 is a cylindrical disk having substantially parallel first 84 and second 86 end surfaces, and an evaporative surface 88 extending therebetween. In a second embodiment (FIG.4), the cathode 36 is an annulus having substantially parallel first 84 and second 86 end surfaces, and an evaporative surface 88 and bore 90 extending between the end surfaces 84,86.

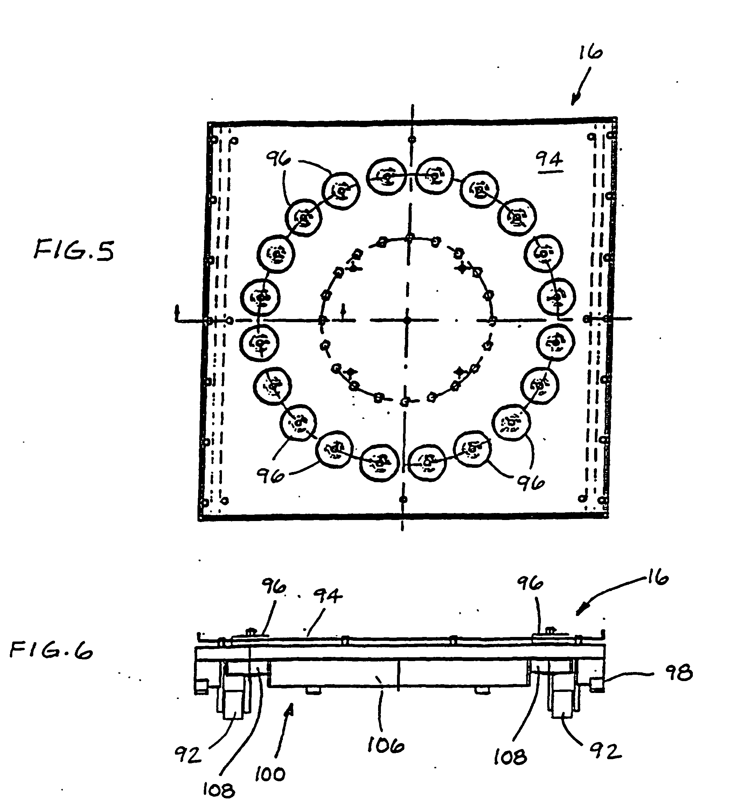

Referring to FIGS. 1,5, and 6, a platter 16 for holding the cathode 36 and substrates 12 is mounted on rollers 92 for easy insertion and removal from the vessel 24. The platter 16 (see FIGS. 5 and 6) includes a tray 94, a plurality of pedestals 96, a rack gear 98 attached to a side of the platter 16, and means 100 for rotating the pedestals 96. The cathode 36 is mounted in the center of the platter 16 (see FIGS. 3 and 4), on top of a spacer 102 and an electrical insulator 104. The means 100 for rotating the pedestals 96 may, for example, include a center gear 106 engaged with a plurality of pedestal gears 108. Each pedestal gear 108 is fixed to a pedestal 96, and the center 106 and pedestal 108 gears are pivotly attached to the tray 94. A gear 110 (see FIG.2) positioned inside the vessel 24 engages the center gear 106 when the platter 16 is positioned inside the vessel 24. A shaft 112 extending through the vessel wall connects the gear 110 to a drive unit (D1), which provides the power means for rotating the substrates 12. A second gear 114 and drive unit (D2) provide a similar function for moving the platter 16 in and out of the vessel 24. The second gear 114, positioned inside the vessel 24, engages the rack gear 98 attached to the platter 16. A shaft 116 extending through the vessel wall connects the second gear 114 to the second drive unit (D2).

Each coater 14 preferably includes a biasing source 118 for electrically biasing the substrates 12. A contact 120, which makes electrical connection with the platter 16, electrically connects the biasing source 118 to the substrates 12 when the platter 16 is installed in the vessel 24. Other means for electrically connecting the substrates 12 to the biasing source 118 may be used alternatively.

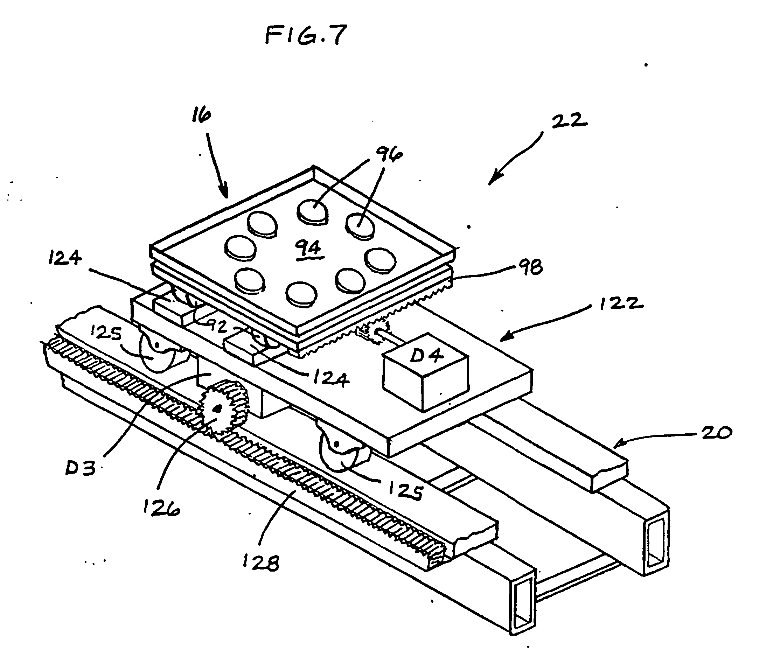

Referring to FIG.7, the preferred means 22 for driving a platter 16 between a coater 14 and the platter docking station 18 is a shuttle car 122. The shuttle car 122 includes a pair of tracks 124 for receiving the rollers 92 of a platter 16, a set of rollers 125 for travel along the shuttle track 20, a third drive unit (D3) for driving the shuttle car 122 along the shuttle track 20, and a fourth drive unit (D4) for loading a platter 16 onto, and off of, the shuttle car 122. The third drive unit (D3) may, for example, be connected to a gear 126 engaged with a rack gear 128 attached to the shuttle track 20.

Referring to FIG. 1, the platter docking station 18 includes a first 130 and a second 132 dock. Each dock 130,132 includes means 134 for loading and unloading a platter 16 into and out of the dock 130,132, respectively. For example, the means 134 for loading and unloading a platter 16 from the dock 130,132 may include a gear 136 engagable with the rack gear 98 of each platter 16, driven by a fifth drive unit (D5) attached to each dock 130,132. The means 134 for loading and unloading a platter 16 from the dock 130,132 further includes a pair of tracks 138 to support the rollers 92 of each platter 16.

Each drive unit (D1-D5), includes a commercially available "drive" which comprises an electric motor coupled with a gear box (not shown). A commercially available position indicator (not shown), such as a shaft-type or a linear-type encoder, is used to indicate relative position. For example, a shaft-type encoder connected to the third drive unit (D3) can be used to determine shuttle car 122 position by equating third drive unit (D3) shaft rotations to linear distance from a known reference point. Alternatively, shuttle car 122 (or platter 16) position could be determined by other means such as limit switches, etc.

A controller 140 having a central processing unit, an input device, an output device, and a memory storage device is used to control each of the coaters 14 and the shuttle car 122, shuttling platters 16 between the coaters 14 and the platter docking station 18. A wide variety of controllers 140 are commercially available. Accordingly, the details of the controller 140 shall be omitted here in favor of the functional requirements of the controller.

### II. Operation of the Apparatus

Referring to FIG. 1, in the operation of the present invention vapor deposition production system 10 for coating substrates 12, an empty platter 16 is positioned in the first dock 130 of the platter docking station 18. An operator (not shown) loads a cathode 36 and substrates 12 to be coated onto the empty platter 16. At the same time, a second platter 16 loaded with coated substrates 12 is cooling in the second dock 132 of the platter docking station 18. At this point in time, one of the coaters 14 is empty, waiting to receive a platter 16 bearing substrates 12 to be coated. After the first platter 16 is loaded with a cathode 36 and substrates 12, the first platter 16 is removed from the first dock 130 and loaded onto the shuttle car 122. The shuttle car 122 transports the loaded platter 16 to the empty coater 14 and the platter 16 is subsequently inserted into the coater 14.

Referring to FIG.2, when the platter 16 is inserted into the coater 14, the actuating cylinders 78 actuate the contactor 32 into contact (physical and electrical) with the cathode 36 and the vessel 24 is closed. The mechanical rough vacuum pump 50 is subsequently operated to evacuate the vessel to a predetermined pressure. Once that pressure is reached, the high-volume diffusion vacuum pump 52 is operated to further evacuate the vessel 24 to near vacuum conditions. The substrates 12 are then cleaned of any remaining contaminants and/or oxidation by a method such as "sputter cleaning". Sputter cleaning is a process well known in the art and will not be described in detail here. Other cleaning methods may be used alternatively. While the substrates 12 are cleaned, the contaminants are purged typically using an inert gas.

Prior to initiating an arc several steps are completed, including: (1) the biasing source 118 is activated and the substrates 12 are electrically biased; (2) the substrates 12 are placed in motion at a particular rotational speed; (3) the power supply 54 is set to establish an arc having a particular magnitude of current and voltage, but no arc is initiated; (4) the vacuum pumps 50,52 establish and maintain a particular vacuum pressure of gas within the vessel 24; and (5) coolant flows are established through the vessel cooling passages 44 and the contactor cooling passages 46. Specific process parameters will depend upon factors such as the substrate 12 material, the material to be coated, and the desired characteristics of the coating, etc.

Once the aforementioned steps have been completed, the arc initiator 56 causes an arc to jump between the cathode 36 and the deflector shields 82 electrically connected to the anodic vessel 24. The magnetic field generator 74 subsequently drives the arc along an arc path 142 (see FIG.3) around the evaporative surface 88 of the cathode 36. The energy delivered by the arc causes the material at the cathode spot to vaporize, thereby liberating atoms, molecules, ions, electrons, and particles from the cathode 36. FIG.3 shows an eroded cathode 36 in phantom. The erosion is substantially symmetrical relative to the arc path 142. The biased substrates 12 attract the ions, causing them to accelerate toward the substrates 12, attach and collectively form a coating of the cathode material. Rotation of the substrates 12 relative to the cathode 36 promotes uniform deposition of the coating on the substrate 12. Coolant passing through the contactor 32 directly cools the contactor 32, and indirectly cools the cathode 36. When a coating of sufficient thickness has been deposited on the substrates 12, the power supply 54 is turned off and the arc extinguished. The vessel 24 is purged with inert gas and brought to ambient pressure. The contactor 32 is actuated out of contact with the cathode 36, the vessel 24 opened, and the platter 16 is removed from the vessel 24 and placed onto the shuttle car 122.

Referring to FIG. 1, during the coating run, the empty shuttle car 122 returns to the platter docking station 18 and the second platter 16 is transported across the shuttle car 122 to the first dock 130. The shuttle car 122 then travels to the next coater 14 to be emptied, receives the platter 16 bearing coated substrates 12 and transports the platter 16 to the platter docking station 18, where the platter 16 is transferred to the second dock 132. Thus, the cycle of coating substrates 12 repeats itself.
The controller 140 provides the command logic for coordinating the tasks of transporting platters 16 along the shuttle track 20, and within the platter docking station 18. For example, the operator (not shown) enters a command to transport the shuttle car 122 bring a platter 16 from a particular coater 14 to the platter docking station 18. The controller 140 compares the actual position of the loaded shuttle car 122 with the stored reference value of the platter docking station 18 and commands the third drive unit (D3) to transport the shuttle car 122 to the platter docking station 18. A real time signal from the position indicator sensing the actual position of the shuttle car 122 is sent to the controller 140 until, the actual position signal coincides with the reference value associated with the platter docking station 18. Similar control logic is used to move the platters 16 in and out of the first 130 and second 132 docks and in and out of the coaters 14.

The controller 140 also provides the command logic for operating each coater 14. The described steps of: (1) opening the vessel 24; (2) actuating the contactor 32 into electrical contact with the cathode 36; (3) operating the vacuum pumps 50,52 to evacuate the coater 14; (4) biasing the substrates 12 via the biasing source 118; (5) rotating the substrates 12 by driving the gears 106,108 attached to the platter 16; (6) creating a potential difference between the cathode 36 and the anodic vessel 24 via the power supply 54; and (7) initiating an arc between the cathode 36 and the deflector shields 82 (or vessel 24); are all coordinated by commands stored within the controller 140. The commands can be created and stored in the form of a software program using a commercially available computer software programming language.

Thus, as may be seen from the above, at least in its preferred embodiments the present invention provides a vapor deposition production system capable of producing a high quality coating on a substrate.

It further provides a vapor deposition production system capable of providing a continuous high-volume stream of coated substrates.

It yet further provides a vapor deposition production system that operates efficiently and cost effectively.

Although this invention has been shown and described with respect to the detailed embodiments thereof, it will be understood by those skilled in the art that various changes in form and detail thereof may be made without departing from the scope of the invention. For example, the described platter docking station 18 is a simplistic version capable of satisfying the present invention production system 10. More complex systems capable of handling more than two platters 16, such as a turret, may be used alternatively. Another change from the preferred embodiment may be found in the drive units. For example, a linear motor could be used to drive the shuffle car and hydraulic actuators could be used to move a platter 16 on and off the shuttle car 122.

## Claims

1. A vapor deposition production system (10) for coating substrates (12), comprising:
a plurality of vapor deposition coaters (14);
a plurality of platters (16);
a platter docking station (18);
a shuttle track (20), connecting said docking station and said coaters;
means (22) for transporting said platters between said coaters and said docking station;
wherein said platters are selectively transported between said coaters and said docking station via said shuffle track, and into, and out of, said coaters.

2. A vapor deposition production system (10) according to claim 1, further comprising:
a controller (140), having a central processing unit, connected to said coaters (14) and said means (22) for transporting said platters, wherein said controller controls the operation of said coaters and the operation of said means for transporting said platters.

3. A vapor deposition production system (10) according to claim 1 or 2, wherein said means (22) for transporting said platters between said coaters (14) and said docking station (18), comprises:
a shuttle car (122), adapted for travel along said shuttle track (20), having a drive means (D3) for propelling said shuttle car.

4. A vapor deposition production system (10) according to claim 2 or 3, wherein each said coater (14) comprises:
a vessel (24);
means (30) for maintaining a vacuum in said vessel;
a cathode (36), mounted on one of said platters (16);
a contactor (32), positioned inside said vessel;
means (38) for selectively sustaining an arc of electrical energy between said cathode and an anode (39), wherein said means for selectively sustaining an arc of electrical energy is electrically connected to said contactor; and
an actuator (34), wherein said actuator selectively actuates said contactor into contact with said cathode, and thereby electrically connects said cathode to said means for sustaining an arc of electrical energy;
wherein said controller (140) controls operation of said means for maintaining a vacuum in said vessel, and said means for selectively sustaining an arc of electrical energy, and said actuator.

5. A vapor deposition production system (10) according to claim 4, wherein said cathode (38) is disk-shaped having a pair of end surfaces (84,86) connected by an evaporative surface (88);
wherein said actuator (34) actuates said contactor (32) into contact with one of said end surfaces of said cathode, thereby electrically connecting said cathode to said means (38) for selectively sustaining an arc of electrical energy.

6. A vapor deposition production system (10) according to claim 5, wherein said coater (14) further comprises means (74) for driving said arc around said evaporative surface (88), wherein said means for driving said arc is positioned in close proximity to said cathode (36), and said means for driving said arc produces a magnetic field that permeates said cathode.

7. A vapor deposition production system (10) according to claim 4, wherein said cathode (36) is annular-shaped having a pair of end surfaces (84,86),
and an evaporative surface (88) and a bore (90) extending between said end surfaces;
wherein said actuator (34) actuates said contactor (32) into electrical contact with said cathode, thereby electrically connecting said cathode to said means (38) for selectively sustaining an arc of electrical energy.

8. A vapor deposition production system according to claim 7, wherein said coater (14) further comprises means (74) for driving said arc around said evaporative surface (88), wherein said means for driving said arc is positioned within said bore (90) of said cathode (36), and said means for driving said arc produces a magnetic field that permeates said cathode.

9. A vapor deposition production system (10) according to any of claims 4 to 8, wherein said contactor (32) comprises:
a head (58), positioned inside said vessel (24);
a shaft (60), attached to said head, extending from said head to outside said vessel.

10. A vapor deposition production system (10) according to any preceding claim, wherein said platter (16) further comprises selectively rotatable pedestals (96), for supporting the substrates (12).

11. A vapor deposition production system (10) according to any preceding claim, further comprising:
a biasing source (118), for electrically biasing the substrates (12) attached to said platters (16) positioned within said coaters (14);
means (120) for electrically connecting said biasing source to the substrates.

12. A vapor deposition production system (10) according to claim 11, wherein said means (120) for electrically connecting said biasing source (118) to the substrates (12) electrically connects said biasing source to said platter (16), and said platter is electrically connected to the substrates.

## Patentansprüche

1. Dampfabscheidungsproduktionssystem (10) zum Beschichten von Substraten (12), aufweisend:
eine Mehrzahl von Dampfabscheidungsbeschichtern (14);
eine Mehrzahl von Platten (16);
eine Plattenandockstation (18);
eine Transportspur (20), die die Andockstation und die Beschichter verbindet;
eine Einrichtung (22) zum Transportieren der Platten zwischen den Beschichtern und der Andockstation;
wobei die Platten selektiv zwischen den Beschichtern und der Andockstation über die Transportspur und in die Beschichter und aus diesen heraus transportiert werden.

2. Dampfabscheidungsproduktionssystem (10) nach Anspruch 1, ferner aufweisend:
eine Steuerung (140) mit einer zentralen Verarbeitungseinheit, die mit den Beschichtern (14) und der Einrichtung (22) zum Transportieren der Platten verbunden ist, wobei die Steuerung den Betrieb der Beschichter und den Betrieb der Einrichtung zum Transportieren der Platten steuert.

3. Dampfabscheidungsproduktionssystem (10) nach Anspruch 1 oder 2, wobei die Einrichtung (22) zum Transportieren der Platten zwischen den Beschichtern (14) und der Andockstation (18) aufweist:
einen Transportwagen (122), der dazu angepasst ist, sich entlang der Transportspur (20) zu bewegen, mit einer Antriebseinrichtung (D3) zum Antreiben des Transportwagens.

4. Dampfabscheidungsproduktionssystem (10) nach Anspruch 2 oder 3, wobei jeder Abscheider (14) aufweist:
einen Behälter (24);
eine Einrichtung (30) zum Aufrechterhalten eines Vakuums in dem Behälter;
eine Kathode (36), die an eine der Platten (16) montiert ist;
einen Kontaktgeber (32), der innerhalb des Behälters angeordnet ist;
eine Einrichtung (38) zum selektiven Erhalten eines Bogens elektrischer Energie zwischen der Kathode und einer Anode (39), wobei die Einrichtung zum selektiven Erhalten eines Bogens elektrischer Energie elektrisch mit dem Kontaktgeber verbunden ist; und
einen Aktuator (34), wobei der Aktuator den Kontaktgeber selektiv in Kontakt mit der Kathode bringt und so die Kathode mit der Einrichtung zum Erhalten eines Bogens elektrischer Energie elektrisch verbindet;
wobei die Steuerung (140) den Betrieb der Einrichtung zum Aufrechterhalten eines Vakuums in dem Behälter und der Einrichtung zum selektiven Erhalten eines Bogens elektrischer Energie und des Aktuators steuert.

5. Dampfabscheidungsproduktionssystem (10) nach Anspruch 4, wobei die Kathode (38) scheibenförmig ist mit einem Paar von Endoberflächen (84, 86), die durch eine Verdampfungsoberfläche (88) verbunden sind;
wobei der Aktuator (34) den Kontaktgeber (32) in Kontakt mit einer der Endoberflächen der Kathode bringt und so die Kathode mit der Einrichtung (38) zum selektiven Erhalten eines Bogens elektrischer Energie elektrisch verbindet.

6. Dampfabscheidungsproduktionssystem (10) nach Anspruch 5, wobei der Beschichter (14) ferner eine Einrichtung (74) zum Treiben des Bogens rund um die Verdampfungsoberfläche (88) aufweist, wobei die Einrichtung zum Treiben des Bogens in enger Nähe zu der Kathoden (36) positioniert ist und die Einrichtung zum Treiben des Bogens ein Magnetfeld erzeugt, das die Kathode durchdringt.

7. Dampfabscheidungsproduktionssystem (10) nach Anspruch 4, wobei die Kathode (36) eine ringförmige Kathode mit einem Paar von Endoberflächen (84, 86) ist,
und sich eine Verdampfungsoberfläche (88) und eine Bohrung (90) zwischen den Endoberflächen erstreckt;
wobei der Aktuator (34) den Kontaktgeber (32) in elektrischen Kontakt mit der Kathode bringt und so die Kathode mit der Einrichtung (38) zum selektiven Erhalten eines Bogens elektrischer Energie elektrisch verbindet.

8. Dampfabscheidungsproduktionssystem nach Anspruch 7, wobei der Beschichter (14) ferner eine Einrichtung (74) zum Treiben des Bogens rund um die Verdampfungsoberfläche (88) aufweist, wobei die Einrichtung zum Treiben des Bogens innerhalb der Bohrung (90) der Kathode (36) positioniert ist und die Einrichtung zum Treiben des Bogens ein Magnetfeld erzeugt, das die Kathode durchdringt.

9. Dampfabscheidungsproduktionssystem (10) nach einem der Ansprüche 4 bis 8, wobei der Kontaktgeber (32) aufweist:
einen Kopf (58), der innerhalb des Gefäßes (24) positioniert ist;
einen Schaft (60), der an dem Kopf angebracht ist und sich von dem Kopf nach außerhalb des Behälters erstreckt.

10. Dampfabscheidungsproduktionssystem (10) nach einem der vorangehenden Ansprüche, wobei die Platte 16 ferner aufweist:
selektiv drehbare Sockel (96), um die Substrate (12) zu halten.

11. Dampfabscheidungsproduktionssystem (10) nach einem der vorangehenden Ansprüche, ferner aufweisend:
eine Vorspannungsquelle (118), um die Substrate (12), die an den innerhalb der Beschichter (14) positionierten Platten (16) angebracht sind, elektrisch vorzuspannen;
eine Einrichtung (120) zum elektrischen Verbinden der Vorspannungsquelle mit den Substraten.

12. Dampfabscheidungsproduktionssystem (10) nach Anspruch 11, wobei die Einrichtung (120) zum elektrischen Verbinden der Vorspannungsquelle (118) mit den Substraten (12) die Vorspannungsquelle mit der Platte (16) elektrisch verbindet und die Platte elektrisch mit den Substraten verbunden ist.

## Revendications

1. Système de production par dépôt en phase vapeur (10) destiné à recouvrir des substrats (12), comprenant :
une pluralité de systèmes d'enduction par dépôt en phase vapeur (14) ;
une pluralité de plateaux (16) ;
un poste d'ancrage de plateau (18) ;
une piste de navette (20), raccordant ledit poste d'ancrage et lesdits systèmes d'enduction ;
des moyens (22) destinés à transporter lesdits plateaux entre lesdits systèmes d'enduction et ledit poste d'ancrage ;
dans lequel lesdits plateaux sont transportés sélectivement entre lesdits systèmes d'enduction et ledit poste d'ancrage par l'intermédiaire de ladite piste de navette, et dans et hors desdits systèmes d'enduction.

2. Système de production par dépôt en phase vapeur (10) selon la revendication 1, comprenant en outre :
un contrôleur (140), comprenant une unité centrale de traitement, raccordé aux dits systèmes d'enduction (14) et aux dits moyens (22) destinés à transporter lesdits plateaux, dans lequel ledit contrôleur commande le fonctionnement desdits systèmes d'enduction et le fonctionnement desdits moyens destinés à transporter lesdits plateaux.

3. Système de production par dépôt en phase vapeur (10) selon la revendication 1 ou 2, dans lequel ledit moyen (22) destiné à transporter lesdits plateaux entre lesdits systèmes d'enduction (14) et ledit poste d'ancrage (18) comprend :
un chariot navette (122), adapté pour se déplacer le long de ladite piste de navette (20), comprenant un moyen d'entraînement (D3) pour propulser ledit chariot navette.

4. Système de production par dépôt en phase vapeur (10) selon la revendication 2 ou 3, dans lequel chacun desdits systèmes d'enduction (14) comprend :
une cuve (24) ;
un moyen (30) destiné à maintenir un vide dans ladite cuve ;
une cathode (36), montée sur un desdits plateaux (16) ;
un contacteur (32), positionné à l'intérieur de ladite cuve ;
un moyen (38) destiné à soutenir sélectivement un arc d'énergie électrique entre ladite cathode et une anode (39), dans lequel ledit moyen destiné à soutenir sélectivement un arc d'énergie électrique est raccordé électriquement audit contacteur ; et
un actionneur (34), ledit actionneur actionnant sélectivement ledit contacteur de façon à le mettre en contact avec ladite cathode et, de ce fait, raccordant électriquement ladite cathode audit moyen destiné à soutenir un arc d'énergie électrique ;
ledit contrôleur (140) commandant le fonctionnement dudit moyen destiné à maintenir un vide dans ladite cuve, et ledit moyen destiné à soutenir sélectivement un arc d'énergie électrique et ledit actionneur.

5. Système de production par dépôt en phase vapeur (10) selon la revendication 4, dans lequel ladite cathode (38) est en forme de disque comprenant une paire de surfaces d'extrémité (84, 86) raccordées par une surface d'évaporation (88) ;
dans lequel ledit actionneur (34) actionne ledit contacteur (32) de façon à le mettre en contact avec une desdites surfaces d'extrémité de ladite cathode, raccordant de ce fait électriquement ladite cathode audit moyen (38) destiné à soutenir sélectivement un arc d'énergie électrique.

6. Système de production par dépôt en phase vapeur (10) selon la revendication 5, dans lequel ledit système d'enduction (14) comprend en outre un moyen (74) destiné à entraîner ledit arc autour de ladite surface d'évaporation (88), ledit moyen destiné à entraîner ledit arc étant positionné à proximité étroite de ladite cathode (36), et ledit moyen destiné à entraîner ledit arc produisant un champ magnétique qui pénètre dans ladite cathode.

7. Système de production par dépôt en phase vapeur (10) selon la revendication 4, dans lequel ladite cathode (36) est de forme annulaire comprenant une paire de surfaces d'extrémité (84, 86) ;
et une surface d'évaporation (88) et un alésage (90) s'étendant entre lesdites surfaces d'extrémité ;
ledit actionneur (34) actionnant ledit contacteur (32) de façon à le mettre en contact électrique avec ladite cathode, raccordant de ce fait électriquement ladite cathode audit moyen (38) destiné à soutenir sélectivement un arc d'énergie électrique.

8. Système de production par dépôt en phase vapeur selon la revendication 7, dans lequel ledit système d'enduction (14) comprend en outre un moyen (74) destiné à entraîner ledit arc autour de ladite surface d'évaporation (88), ledit moyen destiné à entraîner ledit arc étant positionné dans ledit alésage (90) de ladite cathode (36), et ledit moyen destiné à entraîner ledit arc produisant un champ magnétique qui pénètre dans ladite cathode.

9. Système de production par dépôt en phase vapeur (10) selon l'une quelconque des revendications 4 à 8, dans lequel ledit contacteur (32) comprend :
une tête (58), positionnée à l'intérieur de ladite cuve (24) ;
un arbre (60), fixé à ladite tête, s'étendant depuis ladite tête jusqu'à l'extérieur de ladite cuve.

10. Système de production par dépôt en phase vapeur (10) selon l'une quelconque des revendications précédentes, dans lequel ledit plateau (16) comprend en outre des socles sélectivement rotatifs (96), destinés à supporter les substrats (12).

11. Système de production par dépôt en phase vapeur (10) selon l'une quelconque des revendications précédentes, comprenant en outre :
une source de polarisation (118) destinée à polariser électriquement les substrats (12) fixés aux dits plateaux (16) positionnés dans lesdits systèmes d'enduction (14) ;
un moyen (120) destiné à raccorder électriquement ladite source de polarisation aux substrats.

12. Système de production par dépôt en phase vapeur (10) selon la revendication 11, dans lequel ledit moyen (120) destiné à raccorder électriquement ladite source de polarisation (118) aux substrats (12) raccordent électriquement ladite source de polarisation audit plateau (16), et dans lequel ledit plateau est raccordé électriquement aux substrats.
